Europäisches Patentamt

European Patent Office

Office européen des brevets

(19)

(11) Veröffentlichungsnummer: **0 228 141 B1**

# EUROPÄISCHE PATENTSCHRIFT

(12)

(45) Veröffentlichungstag der Patentschrift: **13.11.91**

(51) Int. Cl.5: **C23C 14/34**, C04B 38/04

(21) Anmeldenummer: **86202362.9**

(22) Anmeldetag: **22.12.86**

(54) Verfahren zur Herstellung eines Sputter-Targets.

(30) Priorität: **23.12.85 AT 3723/85**

(43) Veröffentlichungstag der Anmeldung:
**08.07.87 Patentblatt 87/28**

(45) Bekanntmachung des Hinweises auf die
Patenterteilung:
**13.11.91 Patentblatt 91/46**

(84) Benannte Vertragsstaaten:
**BE CH DE ES FR GB IT LI NL SE**

(56) Entgegenhaltungen:
**DE-A- 2 018 032**
**FR-A- 2 255 394**
**US-A- 4 209 375**

**PATENT ABSTRACTS OF JAPAN, Band 10,
Nr. 90 (C-337)[2147], 8. April 1986; & JP-A-60
221 569**

(73) Patentinhaber: **PLANSEE TIZIT GESELL-
SCHAFT M.B.H.**

**A-6600 Reutte/Tirol(AT)**

(72) Erfinder: **Kny, Erich, Dr.**
**Innerwand 8**
**A-6600 Pflach(AT)**

(74) Vertreter: **Lohnert, Wolfgang, Dr.**
**Metallwerk Plansee AG**
**A-6600 Reutte, Tirol(AT)**

**Beschreibung**

Die Erfindung betrifft ein Verfahren zur Herstellung eines Sputter-Targets aus Karbiden und/oder Nitriden und/oder Boriden der Refraktärmetalle.

Das Beschichten verschiedenartigster metallischer und nichtmetallischer Formteile mittels Abdampfen von Targets in Kathodenzerstäubungsanlagen hat in den letzten Jahren sprunghaft an Bedeutung gewonnen und nimmt an Umfang weiter zu. Sputter-Targets aus Karbiden und/oder Nitriden und/oder Boriden der Refraktärmetalle wurden in der Vergangenheit durch Pressen und Sintern oder durch Heißpressen der pulverförmigen Karbide, Nitride, Boride oder Mischungen davon hergestellt. Die erforderlichen Sintertemperaturen bzw. Heißpreß-Temperaturen sind sehr hoch und liegen in der Größenordnung von 2000°C Die nach diesen Herstellungsverfahren erhaltenen Formkörper weisen nur eine geringe mechanische Festigkeit auf, sind nur schlecht mechanisch bearbeitbar und zeigen darüberhinaus eine Neigung zur Rißbildung, und dadurch bedingt eine geringe thermische Belastbarkeit. Werkstoffe mit derartigen Eigenschaften sind für die Verwendung in Sputter-Targets nur sehr bedingt tauglich. Derartige Targets fanden bisher entsprechend wenig Verwendung.

Aus DE-A-2 018 032 ist ein Verfahren zur Herstellung einer Karbidlegierung bekannt, wobei eine gepresste Mischung eines Metallkarbids der IV., V. und VI. Gruppe und ein Kobalt, Nickel, Eisen oder deren Legierung enthaltendes Bindermetall gesintert werden, der Binder chemisch oder elektrochemisch unter Bildung eines Karbidskeletts entfernt wird und der entfernte Binder durch Infiltration eines zweiten andersartigen Binders in das Karbidskelett ersetzt wird.

Die Aufgabe der vorliegenden Erfindung ist es, ein Verfahren zur Herstellung eines Sputter-Targets aus Karbiden und/oder Nitriden und/oder Boriden der Refraktärmetalle zu schaffen, bei denen die genannten Nachteile vermieden werden.

Erfindungsgemäß wird diese Aufgabe dadurch gelöst, daß zunächst ein dichter Verbundkörper als Target-Formkörper aus einem oder mehreren Karbiden und/oder Nitriden und/oder Boriden der Metalle der Gruppe IV A - VI A sowie einem metallischen Bindemittel aus einem oder mehreren Metallen der Eisengruppe auf pulvermetallurgischem Weg mittels Pressen und Sintern hergestellt wird, der Target-Formkörper vorzugsweise vor und/oder nach dem Sintern mechanisch bearbeitet wird und abschließend das Bindemittel durch eine chemische oder elektrochemische Behandlung aus dem Target-Formkörper entfernt wird.

Der Formkörper wird nach an sich bekannten Verfahren durch Pressen und Sintern einer Pulvermischung aus Karbiden und/oder Nitriden und/oder Boriden der Refraktärmetalle sowie Bindemetallpulver hergestellt. Als Bindemittel werden üblicherweise Kobalt, Eisen, Nickel oder Gemische dieser Metalle verwendet. Durch das erfindungsgemäße Verfahren können gegenüber den bekannten Herstellungsverfahren wesentlich niedrigere Sintertemperaturen um etwa 1500 °C verwendet werden. Falls eine mechanische Bearbeitung der Sputter-Targets nötig ist, werden die gesinterten Formkörper noch vor Entfernung des Bindemittels in die endgültige Form gebracht. Auf diese Weise ist eine einfache mechanische Bearbeitung der Sputter-Targets möglich. Nach der mechanischen Formgebung wird der metallische Binder durch ein chemisches oder elektrochemisches Ätzverfahren komplett entfernt.

Es hat sich völlig überraschenderweise herausgestellt, daß auch nach Entfernen des Bindemittels die Sputter-Targets eine große mechanische Festigkeit und eine hohe thermische Belastbarkeit aufweisen. Die für Targets entscheidenden Werkstoffeigenschaften der mechanischen Festigkeit und Thermoschockbeständigkeit liegen wesentlich über den Werten, welche bei nach anderen Verfahren hergestellten Targets bisher erreicht wurden. Die Bindemittel können durch das chemische oder elektrochemische Ätzverfahren nahezu vollständig aus den Sputter-Targets entfernt werden. Die Gehalte an verunreinigenden Elementen wie Sauerstoff, Stickstoff oder Reste der metallischen Bindemittel sind beim erfindungsgemäßen Verfahren äußerst gering und entsprechen den Anforderungen uneingeschränkt, die an Sputter-Targets hinsichtlich dieser Verunreinigungen gestellt werden.

Aus der nachfolgenden Tabelle 1 sind beispielhaft Verunreinigungen und Biegebruchfestigkeiten von verschiedenen Wolframkarbid Sputter-Targets aufgeführt, die nach dem erfindungsgemäßen Verfahren unter Verwendung verschiedener Ausgangsmaterialien hergestellt wurden.

EP 0 228 141 B1

Tabelle 1

| Verunreinigungen und Biegebruchfestigkeit von erfindungsgemäß hergestellten Sputter-Targets | | | | | |
|---|---|---|---|---|---|
| Ausgangsmaterial (Gew.%) | | $O_2$ ppm | $N_2$ ppm | Co-Reste (Gew.%) | BBF (N/mm$^2$) |
| 6%Co 0,3%TaC | Rest WC | 250 | 53 | 0,04 | nicht gemessen |
| 9%Co 0,6%TaC | 0,2% TiC Rest WC | 780 | 12 | 0,04 | nicht gemessen |
| 9%Co 10%TaNbC | 4%TiC Rest WC | 1200 | 1100 | 0,05 | 475 |
| 6%Co 5,5%TaNbC | 5%TiC Rest WC | 1020 | 500 | 0,08 | 614 |
| 6%Co Rest WC | | 175 | - | 0,03 | 395 |

Die Erfindung wird im folgenden anhand eines Beispiels näher erläutert:

Beispiel 1 Scheibenförmige Sputter-Targets aus Wolframkarbid mit einem Endmaß von 75 mm Durchmesser und einer Scheibendicke von 6 mm, wurden auf nachfolgende Weise hergestellt.

0,3 kg eines Kobaltpulvers einer mittleren Korngröße von 1,3 $\mu$m wurden mit 4,7 kg Wolframkarbid-Pulver mit einer mittleren Korngröße von 5,5 $\mu$m gemischt. Der Gesamtkohlenstoff-Gehalt wird mit Rußpulver auf 5,83 % eingestellt. Der Pulveransatz wird 120 Stunden in einer Kugelmühle mit Wolframkarbid-Kugeln und Azeton als Mahlflüssigkeit gemahlen. Nach Beendigung des Mahlvorgangs wird das Azeton durch Destillation entfernt. Die auf diese Weise gewonnene Pulvermischung wurde mit Hilfe eines isostatischen Preßverfahrens bei einem Druck von 1000 bar zu einem zylinderförmigen Preßling verpreßt. Aus dem zylinderförmigen Preßling wurden Scheiben abgetrennt und auf solche Abmessungen gebracht, daß der bei der Sinterung auftretende Schwund von 45 Vol.% berücksichtigt wird und nach erfolgter Sinterung scheibenförmige Körper erhalten werden, die in bezug auf die geforderten Endabmessungen der Sputter-Targets ein geringfügiges Übermaß aufweisen. Nach der mechanischen Bearbeitung wurden die scheibenförmigen Körper während einer Stunde bei 1480°C unter Vakuum gesintert. Die gesinterten scheibenförmigen Körper wurden durch Bearbeitung mit Diamantschleifscheiben auf das geforderte Endmaß gebracht. Anschließend wurden die scheibenförmigen Hartmetallkörper während eines Zeitraumes von etwa 168 Stunden mit kochender, halbkonzentrierter Salzsäure behandelt um die Kobalt-Bindephase herauszulösen. Zur Entfernung von restlicher Salzsäure wurden die scheibenförmigen Sputter-Target erst mit destilliertem Wasser bei 100°C behandelt und dann bei etwa 120°C 24 Stunden lang getrocknet.

Zur Kontrolle, ob die Kobalt-Bindephase vollständig aus den Sputter-Targets herausgelöst wurde, wird die Gewichtsdifferenz, die die Sputter-Targets vor der Salzsäure-Behandlung und nach erfolgter Salzsäure-Behandlung aufweisen als Maß herangezogen. Auch mit Hilfe der magnetischen Sättigung, die bei Kobaltfreiheit null sein muß, ist eine Kontrolle möglich, ob das Kobalt vollständig aus den Sputter-Targets herausgelöst wurde. Falls noch ein Restkobaltgehalt festgestellt wird, werden die Sputter-Targets einer neulichen Behandlung mit frischer, kochender, halbkonzentrierter Salzsäure ausgesetzt, bis die notwendige vollständige Herauslösung der Kobalt-Bindephase erreicht ist.

**Patentansprüche**

1. Verfahren zur Herstellung eines Sputter-Targets aus Karbiden und/oder Nitriden und/oder Boriden der Refraktärmetalle, **dadurch gekennzeichnet,** daß zunächst ein dichter Verbundkörper als Target-Formkörper aus einem oder mehreren Karbiden und/oder Nitriden und/oder Boriden der Metalle der Gruppe IV A - VI A sowie einem metallischen Bindemittel aus einem oder mehreren Metallen der Eisengruppe auf pulvermetallurgischem Weg mittels Pressen und Sintern hergestellt wird, der Target-Formkörper vorzugsweise vor und/oder nach dem Sintern mechanisch bearbeitet wird und abschließend das Bindemittel durch eine chemische oder elektrochemische Behandlung aus dem Target-Formkörper entfernt wird.

2. Verfahren zur Herstellung eines Sputter-Targets nach Anspruch 1, dadurch gekennzeichnet, daß der Verbundkörper aus einem oder mehreren der Karbide aus der Gruppe Wolframkarbid, Titankarbid, Tantalkarbid, Niobkarbid, Zirkonkarbid, Chromkarbid, Molybdänkarbid, mit einem Bindemittel aus einem oder mehreren Metallen der Eisengruppe hergestellt wird.

3

3. Verfahren zur Herstellung eines Sputter-Targets nach Anspruch 1, dadurch gekennzeichnet, daß der Verbundkörper aus einem oder mehreren der Nitride aus der Gruppe Wolframnitrid, Titannitrid, Tantalnitrid, Niobnitrid, Zirkonnitrid, Chromnitrid, Molybdännitrid, mit einem Bindemittel aus einem oder mehreren Metallen der Eisengruppe hergestellt wird.

**Claims**

1. Method of producing a sputtering target made of carbides and/or nitrides and/or borides of refractory metals,
characterized in,
that in a first step a dense compound body, serving as shaped target body, is produced in a powdermetallurgical way by means of pressing and sintering of one or more carbides and/or nitrides and/or borides of group IV A - VI A metals and of a metallic bindermaterial, the binder consisting of one or more metals of the iron group, that in a further step the shaped target body is mechanically treated preferably before or after sintering and that in a final step the bindermaterial is removed from the shaped target body by means of a chemical or electrochemical treatment.

2. Method of producing a sputtering target according to claim 1,
characterized in, that the compound body is produced of one or more carbides of the group tungsten carbide, titanium carbide, tantalum carbide, niobium carbide, zirconium carbide, chromium carbide, molybdenum carbide, with a bindermaterial from one or more metals of the iron group.

3. Method of producing a sputtering target according to claim 1,
characterized in, that the compound body is produced of one or more nitrides of the group tungsten nitride, titanium nitride, tantalum nitride, niobium nitride, zirconium nitride, chromium nitride, molybdenum nitride, with a bindermaterial of one or more metals of the iron group.

**Revendications**

1. Procédé de fabrication d'une cible à pulversiation en carbure et/ou nitrures et/ou borures des métaux réfractaires,
**caractérisé**
en ce que dabord un corps composite dense est produit par procédé de métallurgie des poudres avec pressage et frittage comme cible conformée de un ou plusieurs carbures et/ou nitrures et/ou borures des métaux du groupe IVA - VIA ainsi qu'un liant métalique composé d'un métal ou plusieurs métaux du groupe fers, cette cible conformée est usinée mécaniquement avant et/ou après frittage et en suite le liant est enlevé de cette cible conformée par un traitement chimique ou éléctrochimique.

2. Procédé de fabrication d'une cible à pulversiation selon la revendication 1, caractérisé en ce que le corps composite dense est produit de un ou plusieurs carbures du groupe carbure de tungstène, carbure de titane, carbure de tantale, carbure de niobium, carbure de zirconium, carbure de chrome, carbure de molybdène et qu'en liant composé d'un métal ou plusieurs métaux du groupe fers.

3. Procédé de fabrication d'une cible à pulverisation selon la revendication 1, caractérisé en ce que le corps composite dense est produit de un ou plusieurs nitrures du groupe nitrure de tungstène, nitrure de titane, nitrure de tantale, nitrure de niobium, nitrure de zirconium, nitrure de chrome, nitrure de molybéne et qu'en liant composé d'un métal ou plusieurs métaux du groupe fers.